# EUROPEAN PATENT SPECIFICATION

(11) **EP 1 479 111 B1**
(45) Date of publication and mention of the grant of the patent: **23.04.2008**
(21) Application number: 02702594.9
(22) Date of filing: 21.02.2002
(51) Int. Cl.: H01L 39/14, H01L 39/24

(54) **IMPROVED SUPERCONDUCTORS AND METHODS FOR MAKING SUCH SUPERCONDUCTORS**
VERBESSERTE SUPRALEITER UND DEREN HERSTELLUNGSVERFAHREN
SUPRACONDUCTEURS AMELIORES ET PROCEDES DE FABRICATION DESDITS SUPRACONDUCTEURS

(43) Date of publication of application: 24.11.2004
(73) Proprietor: Mannhart, Jochen Dieter, Prof. Dr., 86321 Königsbrunn (DE); Hammerl, German, 86159 Augsburg (DE); Leitenmeier, Stephan, 86156 Augsburg (DE); Schmehl, Andreas Fritz Albert, 86738 Deiningen (DE); Schneider, Christof Walter, 86343 Königsbrunn (DE)
(72) Inventor: Mannhart, Jochen Dieter, Prof. Dr., 86321 Königsbrunn (DE); Hammerl, German, 86159 Augsburg (DE); Leitenmeier, Stephan, 86156 Augsburg (DE); Schmehl, Andreas Fritz Albert, 86738 Deiningen (DE); Schneider, Christof Walter, 86343 Königsbrunn (DE)
(74) Representative: Barth, Carl Otto
(86) International application number: PCT/IB2002/000584
(87) International publication number: WO 2003/071611

(56) References cited:
- EP-A- 0 634 379
- WO-A-01/08169
- WO-A-01/08233
- US-A- 6 121 205
- US-B1- 6 387 525
- MUROGA T ET AL: "Enhancement of critical current density for Bi-2212/Ag tape conductors through microstructure control" PHYSICA C, vol. 309, no. 3-4, 20 December 1998 (1998-12-20), pages 236-244, XP004153533 ISSN: 0921-4534
- HAMMERL G ET AL: "Large grain boundary area superconductors" EUROPEAN PHYSICAL JOURNAL B, vol. 27, no. 3, June 2002 (2002-06), pages 299-301, XP002217421 ISSN: 1434-6028

## Description

### Technical Field

The present invention relates to superconductors, particularly to the current carrying capabilities of superconductors. It is a proven fact that the critical currents of many superconductors, here polycrystalline superconductors, are limited by grain boundaries formed in them. The invention overcomes this limitation of present superconductors by using alterations for improving the current transport properties of the superconductors' grain boundaries. This is done in principle by optimizing the microstructure of the substrate or of a buffer layer system onto which the superconductor is deposited, such that the polycrystalline superconductor contains large grain boundary areas.

### Background of the Invention

Based on the new class of superconductors, henceforth referred to as high-*T_{c}* superconductors, which were discovered by Bednorz and Müller and disclosed in their article "Possible High-Tc Superconductivity in the Ba-La-Cu-O System", Zeitschrift für Physik B, Condensed Matter, Vol. B64, 1986, pp.189-193, a variety of superconducting wires, cables and tapes have been developed for the transport of electrical current. A key parameter defining the performance and thus the economic benefit of these conductors is given by their so-called critical current density, which is the maximum current these conductors can carry as so-called supercurrents in the superconducting state divided by the cross-sectional area A of the superconductor. The critical current density is a specific property for a given superconductor, and, for the practical use of a superconductor, one aims to maximize the critical current density.

Chaudhari et al. have taught in their article "Direct Measurement of the Superconducting Properties of Single Grain Boundaries in YBa2Cu3O7-δ", Physical Review Letters, Vol. 60, 1988, pp. 1653-1655, that the limiting factor for the critical current density of polycrystalline high-*T_{c}* superconductors is the electronic behavior of the boundaries formed by the crystalline grains of these materials. It was shown that the critical current densities of these grain boundaries are smaller by one to two orders of magnitude than the critical current densities of the grains abutting the grain boundaries.

Further, Dimos et al. have taught in their publication "Superconducting Transport Properties of Grain Boundaries in YBa2Cu3O7-δ Bicrystals", Physical Review B, Vol. 41, 1990, pp. 4038-4049, that superconducting grains with a small misorientation (below typically 8° to 10°) behave as strongly coupled superconductors whereas larger misorientations (also called large-angle grain boundaries) are weakly coupled, showing Josephson junction-like properties. The teaching by Dimos et al. is the finding that the detrimental effect of the grain boundaries can be reduced by aligning the superconducting grains with respect to their crystalline main axes.

Following this proposal, wires and tapes of high-*T_{c}* superconductors have been fabricated, the critical currents of which are enhanced by aligning the superconducting grains by a variety of means, such as rolling processes or ion beam assisted techniques. Although these technologies have lead to the fabrication of high-*T_{c}* superconductors with current densities of the order of 100 000 A/cm² at temperatures of 4.2 K, it remains desirable to fabricate high-*T_{c}* superconductors with still higher critical current densities or with processes which are less costly and faster than the known ones.

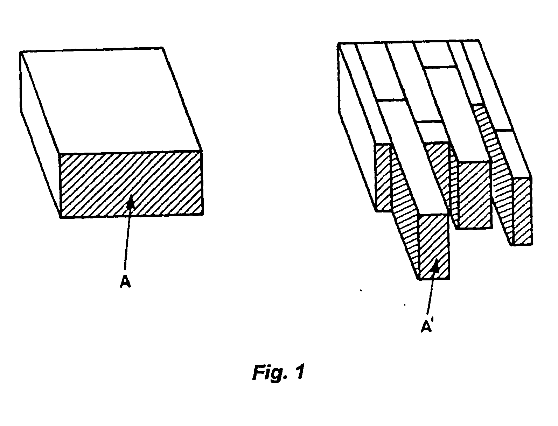

Mannhart and Tsuei have revealed in their publication "Limits of the Critical Current Density of Polycrystalline High-Temperature Superconductors Based on the Current Transport Properties of Single Grain Boundaries", Zeitschrift für Physik B, Vol. 77, 1989, pp 53-59, that the critical current density of a three-dimensional conductor can exceed by an order of magnitude the given critical current density of the grain boundaries. This approach, illustrated in Fig. 1, is based on the fact that the critical current of conductor is a function of the grain boundary critical current density as well as of the effective area *A'* of the grain boundaries, which may be much larger than the cross-sectional area A of the conductor. The effective grain boundary area *A'* may be enhanced, e.g., by adjusting the microstructure of the superconductor such that the grains have a large aspect ratio, the long sides of the grains being oriented predominantly parallel to the supercurrent flow. In their publication, Mannhart and Tsuei also revealed a procedure to calculate the critical current as a function of the grain aspect ratio. These calculations show that the critical current strongly increases with the aspect ratio of the grains, being ultimately limited only by the intragrain critical current densities.

It was pointed out by Mannhart and Tsuei that large critical current densities may be attainable by using superconducting films with aligned needle-shaped grains. Although this proposal shows the right way to fabricate tapes with large critical current, despite more than 10 years of intense R&D efforts on this problem, no way was found to fabricate such conductors. The resulting problematic situation of the field of high-*T_{c}* superconducting cables is presented in "R.F. Service, YBCO confronts life in the slow lane" Science, Vol. 295, page 787 (February 1st, 2002).

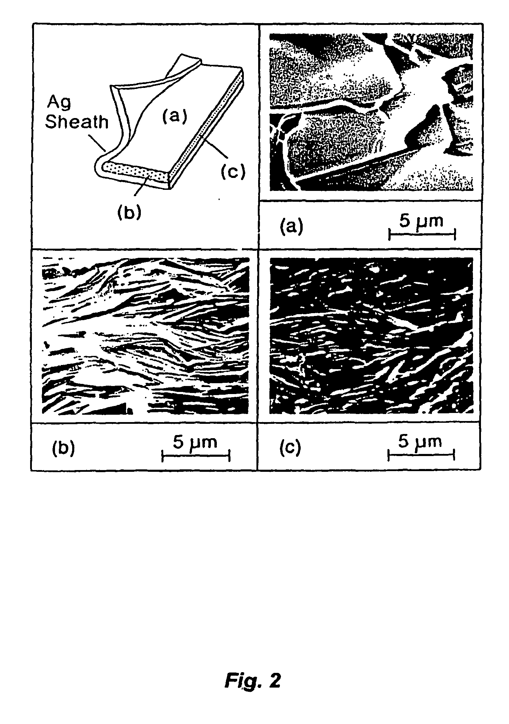

However, in accordance with the proposal of Mannhart and Tsuei, cables based on high-*T_{c}* superconductors such as Bi₂Sr₂Ca₁Cu₂O_{8+δ} or Bi₂Sr₂Ca₂Cu₃O_{10+δ} (BSCCO) so-called first generation cables have been fabricated, which use superconductors which contain platelet-like grains arranged in such a manner that huge effective grain boundary areas are obtained (see Fig. 2 for an illustration). This is described by Mannhart in "Critical Currents in High-Tc Superconductors" in "Physics of High Temperature Superconductors", Proceedings of the Toshiba International School of Superconductivity, Kyoto, Japan, July 15-20, 1991, Springer Series in Solid State Sciences, Vol. 106, 1992, 367-393 (1991). This method, also called powder in tube method, uses large grain boundary areas in bulk BSCCO with success. In this method, Ag-tubes are mechanically filled with BSCCO-powder. The tubes are then drawn and rolled into a final, tube- or tape-like shape and then fired for reaction and annealing. The large grain boundary areas in the bulk BSCCO-filling of the tubes originate from the platelet-like microstructure of the very anisotropic BSCCO-compounds. Unfortunately the material cost involved in the powder in tube process are so high that this technology cannot be commercially competitive. Furthermore, due to the inferior flux pinning properties of the BSCCO compounds, at the preferred operation temperature of 77 K, the critical current density of such wires is low in applied magnetic fields.

Another method to fabricate conductors made of high-*T*_{c} superconductors avoids the use of bulk materials and silver (as done in the powder in tube process), but instead enhances the grain boundary critical current densities by aligning the grains by epitaxially depositing superconducting films. It is this technology, called coated conductor technology, about which the invention is primarily concerned. Tapes fabricated by the coated conductor technology are also called conductors of the second generation, as this process has the potential to solve the cost-problem of the first-generation conductors. The grain alignment (texturing) required at present is achieved, for example, by depositing the superconductor on a template that has a textured surface (an overview of coated conductors is provided by D. Larbalestier et al., "High-Tc Superconducting Materials for Electric Power Applications", Nature, Vol. 414, 2001, pp 368-377 and references therein). Deposition is usually done using standard vapor phase deposition techniques such as sputtering, laser deposition, or thermal evaporation. Recently, non-vacuum techniques like sol-gel methods or dip coating have also been used for this purpose.

At present, coated conductors are fabricated predominantly by using three different processes. In all of them the conductor typically consists of a substrate, for example a metallic tape, a buffer layer system, which usually is based on a series of oxide films, a layer of a high-*T_{c}* superconductor such as YBa₂Cu₃O_{7-δ,} and possibly several doping and capping layers. In contrast to the polycrystalline superconductor of the powder-in tube conductors, the grains in the superconductor layer of the coated conductors generally form a two-dimensional network, because the high-*T_{c}* superconductor is in most cases epitaxially deposited as a polycrystalline film.

The first technique to produce coated conductors to be described here is known as the rolling assisted biaxially textured technique (RABiTS). When tapes of nickel based alloys or similar materials are rolled and suitably heat treated, the Ni-grains become textured along two of their main crystal-axes, so that the grains are aligned in all directions. This makes the metallic tape a useful substrate for the fabrication of a coated conductor. On the surface of the tape a buffer layer, usually composed of CeO₂ and Y-stabilized ZrO₂, is grown. On top of this buffer layer a high-*T_{c}* material, typically YBa₂Cu₃O_{7-δ}, is deposited as film. These epitaxial films reproduce the microstructure of the buffer layer, which in turn has replicated the microstructure of the nickel alloy substrate. The thickness of the superconducting films is in the range of a few microns, the entire tapes being 25-50 micrometers thick. This process, known as the rolling assisted biaxially textured technique (RABiTS) is capable to produce low-angle boundaries (e.g. 5°-8°), consequently, the critical current density is relatively high, reaching values above 10⁵ A/cm² at 77 K in a field of one Tesla.

Texturing can also be induced by ion beam assisted deposition (IBAD) or deposition under a glancing angle, which is the so called inclined substrate deposition method (ISD). In these techniques the buffer layer is textured during growth. This is done in the ISD-process by using a shallow angle between the incoming beam of adatoms and the substrate surface, and in the IBAD technique by irradiating the growing film with additional ions. The critical current densities of the superconducting films, having again a typical thickness of a few micrometers, exceed 10⁶ A/cm² at 77 K and zero external magnetic field. A limiting factor for applications of these processes is their low speed, caused by the cumbersome alignment processes.

Immense efforts are devoted in Asia, the US and in Europe to improve the coated conductor processes. Despite these efforts, possible market applications are at best several years away (see. e.g., "R.F. Service. YBCO confronts life in the slow lane". Science. Vol. 295, page 787, 1 February 2002). The reason is that the texturing of the tapes is a tedious and costly process. Due to this, the maximum length of the coated conductors produced today is approximately ten meters only, and no practical way has been found to produce larger lengths at competitive costs. It is clear that the commercial breakthrough of conductors could be obtained if the current density of the cable could be enhanced significantly for a given grain alignment. Therefore such methods are sought since many years with great intensity as described by P. Grant in "Currents without Borders" Nature Vol. 407, 2000, pp 139-141. If such a method was found, one could benefit for given production costs from an enhanced critical current, or, if the grain alignment was relaxed, from standard critical currents at much lower costs.

A paper by T. Murago, J. Sato, et al., entitled "Enhancement of critical current density for Bi-2212/Ag tape conductors through microstructure control", published in Physica C 309 (1998) pp 236-244, discusses tape conductors with various cross sections but does neither address a solution with a plurality of substrates nor does it address the peculiarities of the materials chosen for implementing the present invention.

The same applies, mutatis mutandis, to WO 01/08169 A2 which discloses coated conductors to be used for power transmission cables, rotor coils of motors and generators, transformers and the like. The specific goal disclosed in this patent application is the minimization of AC losses by using a multilayered tape structure. Though the present invention also concerns a "long" multilayer structure, the WO application concentrates on various coating methods for improving the conduction between the various layers, the disclosed details of which differ significantly from those of the present invention as claimed.

Murakami et al. (USP 6 121 205) describes a bulk superconductor made of a plurality of "units" formed by providing a superconductive paste on a substrate. The substrate of each unit is described as having a length of 50 mm, a width of 10 mm and a thickness of 1 mm. The units are arranged in a row or in a matrix such that the superconductive layers of respective units are superconductively joined with each other to provide an elongated superconductor.

European patent application 634 379 A1 discloses a similar superconducting structure consisting of relatively short superconductive segments or elements soldered together in an overlapping fashion. There is no size given for the elements shown there, but one can conclude from the description that the disclosed segments have a length of no more than about 10 mm and thus must be connected in some way to form a truly long superconductor.

The present invention discloses a superconductive structure which does not assemble short superconductive segments but instead provides an "initially" long superconductor whose characteristics are significantly improved over the prior art by an extensive superconducting contact established between the surfaces of two superconducting layers.

### Summary of the Invention

A general objective of the present invention is to provide a solution for an increased use of high-*T*_{c} and other superconducting materials by improving the current transport mechanisms within such materials, in particular for increasing the upper limit of the achievable supercurrent density within such materials.

A specific objective, as mentioned above, is to provide an approach by which the current carrying capabilities of superconductors, e.g. superconducting wires or tapes, can be significantly improved in a wide temperature range.

A further objective of the invention is to provide a technique for a simpler manufacturing process, resulting in cheaper mass production of polycrystalline superconductors with large critical current densities compared with presently used techniques. At present, the fabrication of such superconductors requires cumbersome and costly processes to optimize the grain boundary alignment.

The novel solution taught by the invention is based on the understanding that the critical current density of coated conductors is a monotonously increasing function of the grain boundary critical current density and of the effective grain boundary area. Therefore, by enhancing the effective grain boundary area, the critical current of such a conductor will considerably exceed the product of the grain boundary critical current density and the geometrical cross-section of the conductor.

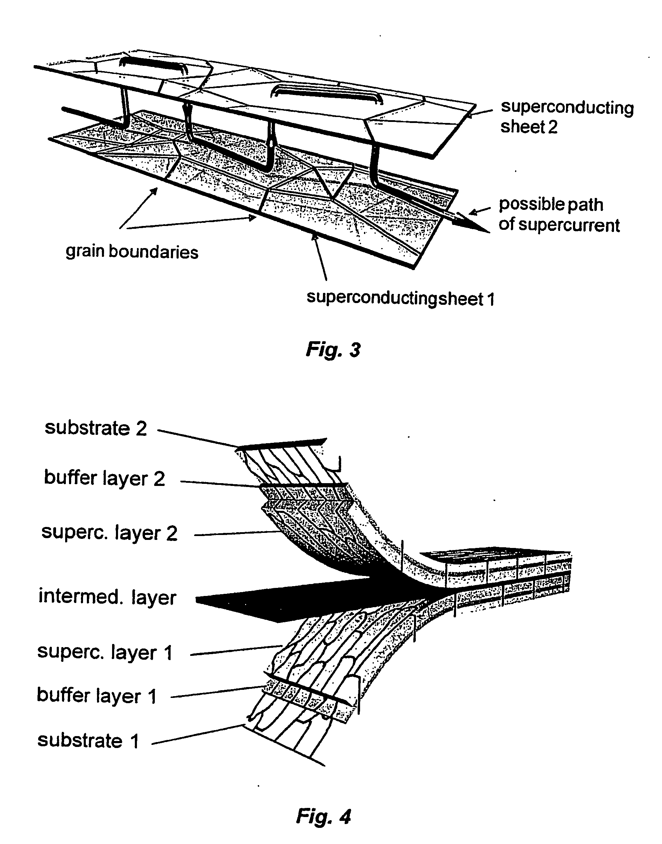

It is the gist of the invention, that for polycrystalline superconductors consisting of grains which are significantly thinner than long or wide, and which are oriented predominantly with their flat side parallel to the superconductor's surface, the effective grain boundary area can be readily enhanced. Intriguingly, such superconductors are the typical superconductors fabricated with the coated conductor technologies. A major enhancement of the grain boundary area is achieved by joining two such superconductors with their superconducting sides facing each other, such that a good superconducting contact is established between the two superconducting layers, as sketched in Fig. 3 and Fig. 4. In this case the supercurrent can meander along the tapes, in part bypassing the grain boundaries within one layer by shifting into grains of the other layer as illustrated in Fig. 3. Hereby the supercurrent can readily pass across the grain boundaries associated with the transition from one layer to the others, as these grain boundaries have a very large area.

In the result a novel superconductor is obtained, the critical current of which exceeds the sum of the critical currents of its constituents.

It is the core of the invention that this enhancement of the critical current density is achieved particularly easily, as various straightforward and inexpensive technologies can be used to establish the required superconducting contacts between the layers.

A preferable way to fabricate superconductors containing flat grains with large aspect ratios is to use the RABiTS technology. The growth is started by using a polycrystalline, textured substrate. Such a template layer is routinely produced by conventional metallurgical processes. In case it is desired, but in many cases this will not even be necessary, these grains may also be oriented such that low angle grain boundaries are formed, as is done in the standard RABiTS process. Onto this layer a buffer layer and the high-*T_{c}* superconductor are deposited as films, such that the shape and the orientation of the grains of the template layer is replicated by the grains of the oxide layer and by the grains of the superconductors.

Coated conductors containing flat, superconducting grains with large aspect ratios may also be obtained using the IBAD or ISD technologies

A superconducting layer fabricated by one of these techniques, consists of a sheet of flat superconducting grains. The critical current density of such a grain-network is given by the critical current density of the so-called limiting path. The limiting path is an area crossing the sheet which is composed by those grain boundaries, of which the sum has the smallest critical current of all such areas. The effective area of the grain boundaries in the limiting path is approximately given by the product of the width and the thickness of the superconductor. This area is small, as the superconductors are usually thin (about 0.5 µm to 1.5 µm).

However, if two of such sheets are brought into intimate superconducting contact, the supercurrent can bypass the grain boundaries in a given sheet, by meandering into the other sheet, as shown in Fig. 3. Thereby the critical current density will be greatly enhanced. This is because the widths and lengths of the grains considerably exceed the film thickness. The effective grain boundary area available for the meandering is therefore much larger than the grain boundary area limiting the current flow within one isolated sheet. This is obvious, because for a given grain, the area available for the current transfer into the other sheet is proportional to the product of the width and length of the grain, whereas the grain boundary area for the current flow within a sheet is approximately the product of the width and the thickness of the grains. For standard RABiTS tapes, for example, the grains have a size of the order of 100 µm*100 µm*1 µm (length * width * thickness), so that both areas differ by two orders of magnitude.

Due to the large grain boundary area the current can therefore transfer easily from one sheet to the next, even if the critical current density of an intersheet grain boundary happened to be small. Likewise, due to the large areas involved, the relatively small critical current density of high-*T*_{c} superconductors for c-axis conduction has no limiting effect. Having passed into the second sheet, the supercurrent can readily flow within a grain, due to the large value of the intragrain critical current density. For a large fraction of the grains in the second sheet, the current can bypass a grain boundary in the first sheet and then transfer again into the first sheet, in many cases without the need to cross a grain boundary with a low critical current density in the second layer (see Fig. 3). The same arguments apply vice versa for the current flowing in the second sheet. Therefore such a double tape will have a critical current density which will exceed significantly the sum of the critical current densities of the individual sheets, the ultimate limit being given by the intragranular critical current density.

In an example, we consider two sheets, each of which consists of grains of a size of approximately of 100 µm*100 µm*0.5 µm (length * width * thickness) with an intragrain critical current density of 5*10⁶ A/cm². Each sheet is supposed to have a critical current density of 10⁵ A/cm² and both sheets are assumed to be coupled by a superconducting contact with a critical current density of 1*10⁴ A/cm². From this we estimate that on average for each grain an area of more than 2 500 µm² is available for current transfer into the next layer. This area can carry a supercurrent of 250 mA, which, in principle may bypass the grain boundary within the first sheet as it corresponds to a intragrain current density of 5*10⁵ A/cm². The boundary in the first sheet carries by itself only a supercurrent of 50 mA. Although this estimation does not consider in any detail complicating percolation effects, it is obvious that a large gain in enhancement of the critical current (from 50 mA to 250 mA in the example) can be achieved by joining such two sheets.

The increase of the critical current of the conductor will take place also in applied magnetic fields and for all temperatures below the superconducting transition temperature, which presents significant advantages for applications.

Another advantage of the invention is that it simplifies the manufacturing process of superconductors for technical applications by allowing cheaper mass production of polycrystalline high-*T_{c}* and other superconductors with large critical current densities. This is the case because the large current densities achieved by the invention relax the requirements on the costly and tedious grain alignment.

In the following, implementations of the invention shall be described, illustrated by the appended drawings.

### Brief Description of the Drawings

*Fig. 1* shows a sketch to illustrate that in a polycrystal grain boundaries provided by grains with large aspect ratios (on the right) can have an effective area *A'* which considerably exceeds the cross-sectional area *A* of the polycrystal. The figure has been taken from Mannhart and Tsuei "Limits of the Critical Current Density of Polycrystalline High-Temperature Superconductors Based on the Current Transport Properties of Single Grain Boundaries", Zeitschrift für Physik B, Vol. 77, 1989, pp 53-59.
*Fig. 2* shows a scanning electron microscopy image of a Ag-sheated Bi-based powder in tube conductor. Interconnected sheet-like BSCCO platelets are clearly visible. The figure has been taken from Y. Yamada et al. "Properties of Ag-Sheated Bi-Pb-Sr-Ca-Cu-O Superconducting tapes Prepared by the Intermediate Pressing Process", Jpn. J. Appl. Phys. Vol. 29, 1990, L 456-458. The micrographs (a), (b), (c) present side-views, as shown in the sketch in the upper left.
Fig. 3 is an illustration showing how a current can meander between two sheets of polycrystalline superconductors, bypassing the critical current limiting grains boundaries in the sheets.
Fig. 4 is an illustration showing as an example how a superconductor with a large critical current density can be formed by joining two coated conductors.

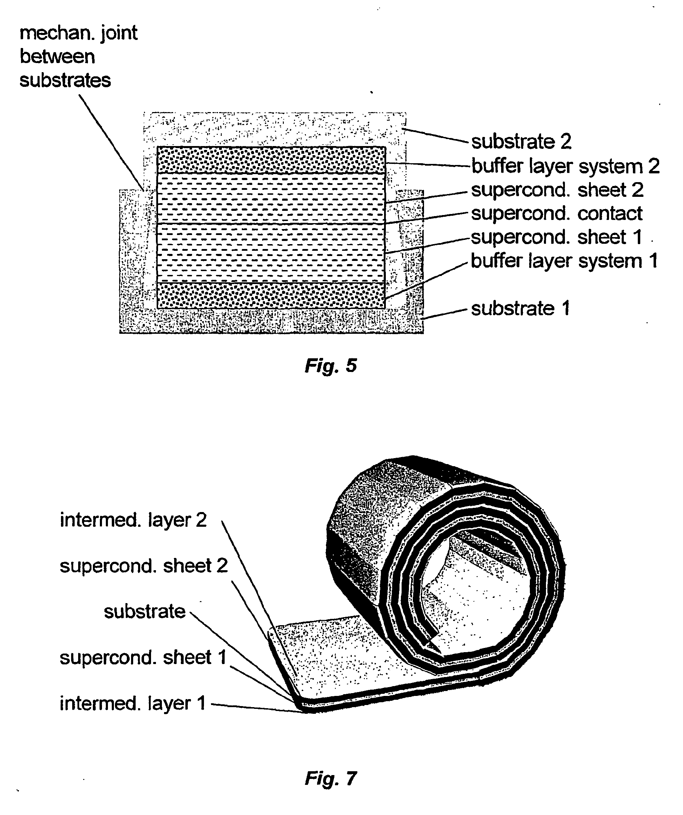

Fig. 5 is an illustration of a cross-section of a superconductor containing two superconducting sheets on two substrates. The substrates are clamped by a mechanical joint, so that the resulting force establishes a superconducting contact between the two superconducting sheets.

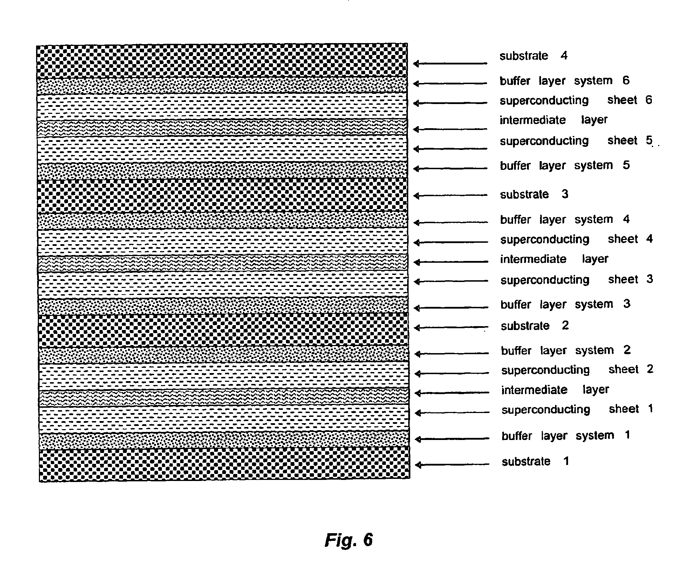

Fig. 6 is a sketch of a superconductor containing six superconducting layers or sheets on four substrates fabricated with a coated conductor process. The superconducting sheets are welded together by melting the intermediate layer, which has a lower melting temperature than the two superconducting sheets.
Fig. 7 is an illustration of a superconductor containing two superconducting sheets deposited two-sided on a flexible substrate. By rolling the sample, the superconducting sheets are brought into contact via an intermediate layer. The superconducting sheets are welded together by melting intermediate layers, which have a lower melting temperature than the two superconducting sheets.

### Description of Examples and Embodiments

We provide in the following examples for the fabrication of the superconductors according to the invention. As basis for the examples, we use standard coated conductors available at present.

### Example 1:

In the first embodiment, two YBa₂Cu₃O_{7-δ} tapes are used which are fabricated by a standard RABiTS Procedure. As substrate a Ni-alloy tape, e.g., Ni-W with a thickness in the range of 20 µm to 100 µm, is employed. According to the standard, published procedures, the tape is rolled and heated, so that a surface texture with aligned grains is produced, although the alignment of the grains is not a critical prerequisite for the invention. The surface orientation of the tape (for Ni, e.g. (111)) has to be chosen to be appropriate for the later growth of a superconductor. On such tapes a buffer layer system is deposited. Such a buffer layer, which itself may consist of various sublayers such as CeO₂/YsZ/CeO₂, is deposited on the carrier tape to prevent chemical reactions between the high-*T*_{c} film and the carrier tape material, or, e.g, the oxidation of the carrier tape during the growth of the superconductor.

A variety of materials have been found useful as buffer-layers. Beside the YSZ and CeO₂ compounds already mentioned, NiO, LaTiO₃, MgO or SrTiO₃ have been used successfully, to name a few examples. These buffer-layers are usually grown by standard technologies, such as sputtering, e-beam, or thermal evaporation, pulsed laser deposition or metal organic chemical vapor deposition (MOCVD). But also other non-vacuum techniques may be employed, such as dip-coating, spray-coating, or painting techniques.

Like the buffer-layers, for the high-*T*_{c} superconductors a variety of materials, or multilayers may be used, again deposited by a multitude of techniques. Standard materials are, for example, members of the so-called 123-family, comprising the ReBa₂Cu₃Oₓ family, where Re is Y or a rare earth and x is a number of the order of seven. Into the superconductor additional layers, e.g., doping layers may be embedded, as described by P. Grant in "Currents without Borders", Nature Vol. 407, 2000, pp 139-141. Here we will consider as example YBa₂Cu₃O_{7-δ}. Those skilled in the art will easily recognize many more variations of this scheme. These layers may be grown by using a variety of film growth techniques, such as such as sputtering, e-beam or thermal evaporation, pulsed laser deposition or MOCVD. But here again, other non-vacuum techniques, like, e.g., dip-coating, spray-coating, or painting processes may be utilized.

The two tapes fabricated this way are then mounted together with their superconducting layers facing each other. During the time between growth of the superconductor and joining of the tapes, the superconductors should not be exposed to any atmosphere causing degradation of the film's surfaces, including humidity. Therefore these process steps have best to be carried out in a nitrogen or oxygen atmosphere. A firm contact between the superconducting layers is established by mechanically fixing the tapes, for example by folding and pressing the two substrate tapes as shown in Fig. 5.

### Example 2:

The second example is again based on coated conductor tapes, fabricated as described in example 1, the difference being that the buffer layers and superconductors are deposited on both sides of the tapes. After the high-*T_{c}* superconductor, e.g. YBa₂Cu3O_{7-δ} has been deposited, another layer, the intermediate layer, is grown, which is also superconducting, but has a lower melting temperature than YBa₂Cu₃O_{7-δ}. As revealed by T. Puig et al. in "Self-seeded YBCO welding induced by Ag additives", Physica C Vol 363, pages 75-79, such a layer may consist, for example, of a 15 wt% Ag + 0.7 YBa₂Cu₃O_{7-δ} O+0.3Y₂BaCuO₅ composite, the melting temperature of which is about 40°C lower than that of YBa₂Cu₃O_{7-δ}. The superconductors are again placed on top of each other and are heated under slight pressure to a temperature of about 990°C in an appropriate atmosphere (e.g. 0.5 bar of O₂), as revealed by T. Puig et al. A superconductor fabricated this way is sketched as illustration in Fig. 6. It is clear, that several of such tapes can be welded together. A similar procedure to establish a suitable contact between two superconductors is revealed in the European Patent Application 93102579.5, publication number: 0 556 837 A1.

### Example 3:

The superconductor presented as third example is based on a double-sided superconducting tape including a layer with a lower melting temperature than described in example 2. This tape is then rolled up, as sketched in Fig. 7, and welded together like the superconductor in example 2.

In a modification of this embodiment, a tape covered with a superconducting layer, possibly even on one side only, is folded such that the superconducting layer is folded onto itself and a superconducting contact is established between various areas of one single superconducting layer. This folding step can be repeated several times to obtain a stack of superconducting double-layers.

It is obvious to persons working in the field of superconductivity that, by using the invention, not only tapes for current transport can be fabricated, but that the invention also lends itself for the production of superconductors to be used for other purposes. By using the invention it is readily possible, for example, to fabricate superconducting foils or plates, which do not only have a substantial length, but also have a large width. Such foils or plates are highly suitable, for example, for magnetic shielding purposes.

Persons skilled in the art can apply this invention for cheaper mass production of superconducting tapes or wires, operated preferentially at 77 K or at any other temperature suitable for power applications or the design of strong magnets.

The main advantages offered by the invention, namely the enhanced current-carrying capabilities and the reduced sensitivity to magnetic fields, reduces the costly and cumbersome requirements to align the superconducting grains for wires as it is presently done for coated conductors. These properties make a superconductor according to the present invention perfectly suitable for many applications, e.g. as superconducting cables, wires or tapes, which have not been competitive and thus hardly marketable until now. With the invention, superconductors will become less expensive and thus broadly marketable and competitive for many applications.

Based on the above description and the given examples and applications, a person skilled in the art can easily vary the described invention, its values, and its materials given above, and adapt the invention to other implementations without departing from the inventive gist as defined in the appended claims.

## Claims

1. An extended polycrystalline superconductor, e.g. a superconducting tape, or wire, or foil, ***characterized by***
• at least two substrates each having a length of at least 1 m,
• each said substrate having deposited on at least one side a superconducting layer, preferably on a buffer layer on said substrate, and
• an extensive superconducting contact established between the surfaces of said superconducting layers and extending over at least a fraction of f = 0.3 of the length and width of said superconductor by joining two said substrates with their superconducting sides facing each other.

2. An extended polycrystalline superconductor, e.g. a superconducting tape, or wire, or foil, ***characterized by***
• a single substrate having a length of at least 1 m and having deposited thereon at least one superconducting layer, preferably on a buffer layer on said substrate, and
• an extensive superconducting contact established by folding said substrate with said deposited superconductor layer onto itself, thereby establishing a superconducting contact between different areas of said superconducting layer and extending over at least a fraction of *f* = 0.3 of the length and width of said superconductor,
• at least one of said superconducting layers comprising a compound belonging to the ReBa₂Cu₃O_{7-δ} family, Re being a rare earth including La or Y.

3. An extended polycrystalline superconductor, e.g. a superconducting tape, or wire, or foil, ***characterized by***
• a single substrate having a length of at least 1 m,
• having deposited thereon a first superconducting layer, preferably on a buffer layer, on a first side of said substrate, and
• having deposited thereon a second superconducting layer, preferably on a buffer layer, on a second side, opposite to said first side of said substrate,
• an extensive superconducting contact established by rolling said substrate with said deposited superconducting layers, thereby establishing said extensive contact between the surface of said first superconducting layer and the surface of said second superconducting layer, said extensive contact extending over at least a fraction of *f* = *0.3* of the length and width of said superconductors,
• at least one of said superconducting layers comprising a compound belonging to the ReBa₂Cu₃O_{7-δ} family, Re being a rare earth including La or Y.

4. The superconductor according to any of the preceding claims, *wherein*
the superconducting layers in contact are of preferably different lengths or widths and said contact extends at least over a fraction of about *f* = 0.5 of the length and width of one of said superconducting layers.

5. The superconductor according to any of the preceding claims, *wherein*
the grains in at least one superconducting layer are aligned so that low-angle grain boundaries are obtained.

6. The superconductor according to any of the preceding claims, *wherein*
the average length of the grains in at least one superconducting layer exceeds their average width by at least a factor of 1.5.

7. The superconductor according to any of the preceding claims, *wherein*
at least one of the superconducting layers consists of a heterostructure.

8. The superconductor according to claim 7, *wherein*
the heterostructure includes at least one doping film.

9. The superconductor according to any of the preceding claims, *wherein*
the superconducting contact is established by pressing the superconducting layers together with mechanical means.

10. The superconductor according to any of the claims 1 to 9, *wherein*
the superconducting contact is established by sintering and/or soldering the superconducting layers together.

11. The superconductor according to any of the claims 1 to 9, *wherein*
the superconducting contact is established by welding the superconducting layers together.

12. The superconductor according to claim 10 or 11, *wherein*
the superconducting contact is established while pressure is applied.

13. The superconductor according to any of the claims 9 to 12, *wherein*
the superconducting contact is established by providing an intermediate layer, particularly an intermediate layer deposited onto at least one of the superconducting layers.

14. The superconductor according to claim 13, *wherein*
the intermediate layer comprises a powder deposited onto at least one of the superconducting layers.

15. The superconductor according to any of the preceding claims, *wherein*
at least one of the substrates is removed before establishing the superconducting contact between the surfaces of the superconducting layers.

16. The superconductor according to any of the preceding claims, *wherein*
at least one superconducting layer is separated into pieces before establishing the superconducting contact.

17. The superconductor according to any of the preceding claims, *wherein*
at least one of the superconducting compounds used in any of the superconducting layers is a cuprate.

18. The superconductor according to claim 1, *wherein*
at least one of the superconducting compounds used in any of the superconducting layers belongs to the ReBa₂Cu₃O_{7-δ} family, Re being a rare earth including La or Y.

19. The superconductor according to claim 18, *wherein*
• metallic substrates are provided,
• the superconducting compound of the ReBa₂Cu₃O_{7-δ} family is deposited on both sides of said substrates, preferably onto buffer layers, and
• at least two of these substrates carrying superconducting layers are mounted on top of each other over at least a third of their length or width.

20. A method for making an extended superconductor, e.g. a wire, tape, or foil, ***characterized by***
• providing at least two substrates, each of a length of at least 1 m, preferably several m,
• depositing on each said substrate on at least one side a superconducting layer, preferably onto an intermediate buffer layer on said substrate,
• establishing an extensive superconducting contact between the surfaces of said superconducting layers, said superconducting contact extending over at least a fraction of *f* = *0.3* of the length and width of said superconducting layers by joining two said substrates with their superconducting sides facing each other.

21. A method for making an extended superconductor, e.g. a wire, tape, or foil, ***characterized by***
• providing a single substrate of a length of at least 1 m,
• depositing thereon at least one superconducting layer, preferably onto an intermediate buffer layer on said substrate,
• folding or twisting said substrate onto itself so that different areas of said superconducting layer establish an extensive superconducting contact extending over at least a fraction of *f* = *0.3* of the length and width of said different areas of said superconducting layer,
• at least one of said superconducting layers comprising a compound belonging to the ReBa₂Cu₃O_{7-δ} family, Re being a rare earth including La or Y.

22. A method for making an extended superconductor, e.g. a wire, tape, or foil, ***characterized by***
• providing a single substrate of a length of at least 1 m,
• depositing on a first side of said substrate a first superconducting layer, preferably on a buffer layer, and
• depositing on a second side, opposite to said first side, of said substrate a second superconducting layer, preferably on a buffer layer,
• rolling said substrate with said deposited superconducting layers so that an extensive contact between the surface of said first superconducting layer and the surface of said second superconducting layer is established, said extensive contact extending over at least a fraction of f = 0.3 of the length and width of said superconductors,
• at least one of said superconducting layers comprising a compound belonging to the ReBa₂Cu₃O_{7-δ} family, Re being a rare earth including La or Y.

23. The method for making a superconductor according to claim 20, 21 or 22, *wherein*
the superconducting layer is obtained by depositing a superconducting compound onto a substrate, preferably onto a buffer layer on said substrate, thus producing a multilayer and subsequently separating or splicing the multilayer obtained this way.

## Patentansprüche

1. Ausgedehnter polykristalliner Supraleiter, z. B. ein supraleitendes Band oder ein supraleitender Draht oder eine supraleitende Folie, ***gekennzeichnet durch***
• mindestens zwei Substrate, die jeweils eine Länge von mindestens 1 m aufweisen,
• wobei jedes Substrat auf mindestens einer Seite eine vorzugsweise auf einer Pufferschicht auf dem Substrat abgeschiedene supraleitende Schicht aufweist und
• einen ausgedehnten supraleitenden Kontakt zwischen den Oberflächen der supraleitenden Schichten, der sich mindestens über einen Bruch von f = 0,3 der Länge und Breite des Supraleiters erstreckt, der **durch** das Zusammenfügen der zwei Substrate, so dass ihre Supraleitenden Seiten einander zugewandt sind, hergestellt wird.

2. Ausgedehnter polykristalliner Supraleiter, z. B. ein supraleitendes Band oder ein supraleitender Draht oder eine supraleitende Folie, ***gekennzeichnet durch***
• ein einziges Substrat, das eine Länge von mindestens 1 m aufweist und auf dem mindestens eine supraleitende Schicht abgeschieden ist, vorzugsweise auf einer Pufferschicht auf dem Substrat, und
• einen ausgedehnten supraleitenden Kontakt, der **durch** Falten des Substrats mit der abgeschiedenen Supraleiterschicht auf sich selbst hergestellt wird, wodurch ein supraleitender Kontakt zwischen verschiedenen Bereichen der supraleitenden Schicht hergestellt wird, der sich über mindestens einen Bruch von f = 0,3 der Länge und Breite des Supraleiters erstreckt, und
• wobei mindestens eine der supraleitenden Schichten eine zur Familie ReBa₂Cu₃O_{7-δ} gehörende Verbindung umfasst, wobei Re eine seltene Erde einschließlich La oder Y ist.

3. Ausgedehnter polykristalliner Supraleiter, z. B. ein supraleitendes Band oder ein supraleitender Draht oder eine supraleitende Folie, ***gekennzeichnet durch***
• ein einziges Substrat, das eine Länge von mindestens 1 m aufweist,
• wobei darauf eine erste supraleitende Schicht abgeschieden ist, vorzugsweise auf einer Pufferschicht auf einer ersten Seite des Substrats, und
• wobei darauf eine zweite supraleitende Schicht abgeschieden ist, vorzugsweise auf einer Pufferschicht auf einer zweiten, der ersten Seite des Substrats gegenüberliegenden Seite,
• einen ausgedehnten supraleitender Kontakt, der **durch** Rollen des Substrats mit den abgeschiedenen supraleitenden Schichten hergestellt wird, wodurch der ausgedehnte Kontakt zwischen der Oberfläche der ersten supraleitenden Schicht und der Oberfläche der zweiten supraleitenden Schicht hergestellt wird, wobei der ausgedehnte Kontakt sich über mindestens einen Bruch von f = 0.3 der Länge und Breite der Supraleiter erstreckt,
• wobei mindestens eine der supraleitenden Schichten eine zur Familie ReBa₂Cu₃O_{7-δ} gehörende Verbindung umfasst, wobei Re eine seltene Erde einschließlich La oder Y ist.

4. Supraleiter nach einem der vorangehenden Ansprüche, *wobei*
die Kontakt habenden supraleitenden Schichten vorzugsweise verschiedene Längen oder Breiten aufweisen und der Kontakt sich mindestens über einen Bruch von ca. f = 0,5 der Länge und Breite einer der supraleitenden Schichten erstreckt.

5. Supraleiter nach einem der vorangehenden Ansprüche, *wobei*
die Körner in mindestens einer supraleitenden Schicht ausgerichtet sind, so dass Kleinwinkelkörnergrenzen erhalten werden.

6. Supraleiter nach einem der vorangehenden Ansprüche, *wobei*
die durchschnittliche Länge der Körner in mindestens einer supraleitenden Schicht um mindestens einen Faktor von 1.5 größer als deren durchschnittliche Breite ist.

7. Supraleiter nach einem der vorangehenden Ansprüche, *wobei*
mindestens eine der supraleitenden Schichten aus einer Heterostruktur besteht.

8. Supraleiter nach Anspruch 7, *wobei*
die Heterostruktur mindestens einen Dotierungsfilm umfasst.

9. Supraleiter nach einem der vorangehenden Ansprüche, *wobei*
der supraleitende Kontakt durch Zusammenpressen der supraleitenden Schichten mit mechanischen Mitteln hergestellt wird.

10. Supraleiter nach einem der Ansprüche 1 bis 9, *wobei*
der supraleitende Kontakt durch Sintern und/oder Verlöten der supraleitenden Schichten hergestellt wird.

11. Supraleiter nach einem der Ansprüche 1 bis 9, *wobei*
der supraleitende Kontakt durch Zusammenschweißen der supraleitenden Schichten hergestellt wird.

12. Supraleiter nach Anspruch 10 oder 11, *wobei*
der supraleitende Kontakt unter Anwendung von Druck hergestellt wird.

13. Supraleiter nach einem der Ansprüche 9 bis 12, *wobei*
der supraleitende Kontakt durch die Schaffung einer Zwischenschicht, insbesondere einer auf mindestens einer der supraleitenden Schichten abgeschiedenen Zwischenschicht, hergestellt wird.

14. Supraleiter nach Anspruch 13, *wobei*
die Zwischenschicht ein auf mindestens einer der supraleitenden Schichten abgeschiedenes Pulver umfasst.

15. Supraleiter nach einem der vorangehenden Ansprüche, *wobei*
mindestens eines der Substrate vor der Herstellung des supraleitenden Kontakts zwischen den Oberflächen der supraleitenden Schichten entfernt wird.

16. Supraleiter nach einem der vorangehenden Ansprüche, *wobei*
mindestens eine supraleitende Schicht vor der Herstellung des supraleitenden Kontakts unterteilt wird.

17. Supraleiter nach einem der vorangehenden Ansprüche, *wobei*
mindestens eine der in einer der supraleitenden Schichten verwendeten supraleitenden Verbindungen ein Kuprat ist.

18. Supraleiter nach Anspruch 1, *wobei*
mindestens eine der in einer der supraleitenden Schichten verwendeten supraleitenden Verbindungen zur Familie ReBa₂Cu₃O_{7-δ} gehört, wobei Re eine seltene Erde einschließlich La oder Y ist.

19. Supraleiter nach Anspruch 18, *wobei*
• metallische Substrate bereitgestellt werden,
• die supraleitende Verbindung der Familie ReBa₂Cu₃O_{7-δ} auf beiden Seiten der Substrate, vorzugsweise auf Pufferschichten, abgeschieden wird und
• mindestens zwei dieser Substrate, die supraleitende Schichten tragen, über mindestens ein Drittel ihrer Länge oder Breite aufeinander angebracht sind.

20. Verfahren zur Herstellung eines ausgedehnten Supraleiters, z. B. eines Drahts, eines Bands oder einer Folie, ***gekennzeichnet durch***
• Bereitstellen von mindestens zwei Substraten, jedes mit einer Länge von mindestens 1 m, vorzugsweise mehreren m,
• Abscheiden einer supraleitenden Schicht auf jedem Substrat auf mindestens einer Seite, vorzugsweise auf einer Pufferzwischenschicht auf dem Substrat,
• Herstellen eines ausgedehnten supraleitenden Kontakts zwischen den Oberflächen der supraleitenden Schichten, wobei der supraleitende Kontakt sich über mindestens einen Bruch von f = 0,3 der Länge und Breite der supraleitenden Schichten erstreckt, **durch** Zusammenfügen der zwei Substrate, so dass ihre supraleitenden Seiten einander zugewandt sind.

21. Verfahren zur Herstellung eines ausgedehnten Supraleiters, z. B. eines Drahts, eines Bands oder einer Folie, ***gekennzeichnet durch***
• Bereitstellen eines einzigen Substrats mit einer Länge von mindestens 1 m,
• Abscheiden mindestens einer supraleitenden Schicht darauf, vorzugsweise auf einer Pufferzwischenschicht auf dem Substrat,
• Falten oder Verdrehen des Substrats auf sich selbst, so dass verschiedene Bereiche der supraleitenden Schicht einen ausgedehnten supraleitenden Kontakt herstellen, der sich über mindestens einen Bruch von f = 0,3 der Länge und Breite der verschiedenen Bereiche der supraleitenden Schicht erstreckt,
• wobei mindestens eine der supraleitenden Schichten eine zur Familie ReBa₂Cu₃O_{7-δ} gehörende Verbindung umfasst, wobei Re eine seltene Erde einschließlich La oder Y ist.

22. Verfahren zur Herstellung eines ausgedehnten Supraleiters, z. B. eines Drahts, eines Bands oder einer Folie, ***gekennzeichnet durch***
• Bereitstellen eines einzelnen Substrats mit einer Länge von mindestens 1 m,
• Abscheiden einer ersten supraleitenden Schicht auf einer ersten Seite des Substrats, vorzugsweise auf einer Pufferschicht, und
• Abscheiden einer zweiten supraleitenden Schicht auf einer zweiten, der ersten Seite gegenüberliegenden Seite des Substrats, vorzugsweise auf einer Pufferschicht,
• Rollen des Substrats mit den abgeschiedenen supraleitenden Schichten, so dass ein ausgedehnter Kontakt zwischen der Oberfläche der ersten supraleitenden Schicht und der Oberfläche der zweiten supraleitenden Schicht hergestellt wird, wobei der ausgedehnte Kontakt sich über mindestens einen Bruch von f = 0,3 der Länge und Breite der Supraleiter erstreckt,
• wobei mindestens eine der supraleitenden Schichten eine zur Familie ReBa₂Cu₃O_{7-δ} gehörende Verbindung umfasst, wobei Re eine seltene Erde einschließlich La oder Y ist.

23. Verfahren zur Herstellung eines Supraleiters nach Anspruch 20, 21 oder 22, *wobei*
die supraleitende Schicht erhalten wird, indem eine supraleitende Verbindung auf einem Substrat, vorzugsweise auf einer Pufferschicht auf dem Substrat, abgeschieden wird, so dass eine Mehrfachschicht hergestellt wird, und anschließend die so erhaltene Mehrfachschicht aufgetrennt oder gespleißt wird.

## Revendications

1. Supraconducteur polycristallin étendu, par exemple une bande, un fil ou une feuille supraconducteur/supraconductrice, ***caractérisé par***
• au moins deux substrats ayant chacun une longueur d'au moins 1 m,
• une couche supraconductrice déposée sur au moins un côté de chaque substrat, de préférence sur une couche tampon sur ledit substrat, et
• un contact supraconducteur de grande envergure établi entre les surfaces desdites couches supraconductrices et s'étendant sur au moins une fraction de f = 0,3 de la longueur et de la largeur dudit supraconducteur en réunissant lesdits deux substrats avec leurs côtés supraconducteurs se faisant face.

2. Supraconducteur polycristallin étendu, par exemple une bande, un fil ou une feuille supraconducteur/supraconductrice, ***caractérisé par***
• un substrat unique ayant une longueur d'au moins 1 m et sur lequel est déposée au moins une couche supraconductrice, de préférence sur une couche tampon sur ledit substrat, et
• un contact supraconducteur de grande envergure établi en pliant sur lui-même ledit substrat avec ladite couche supraconductrice déposée, établissant ainsi un contact supraconducteur entre différentes zones de ladite couche supraconductrice et s'étendant sur au moins une fraction de f = 0,3 de la longueur et de la largeur dudit supraconducteur,
• au moins une desdites couches supraconductrices comprenant un composé appartenant à la famille ReBa₂Cu₃O_{7-δ}, Re étant une terre rare incluant La ou Y.

3. Supraconducteur polycristallin étendu, par exemple une bande, un fil ou une feuille supraconducteur/supraconductrice, ***caractérisé par***
• un substrat unique ayant une longueur d'au moins 1 m,
• une première couche supraconductrice déposée sur le substrat, de préférence sur une couche tampon, sur un premier côté dudit substrat, et
• une deuxième couche supraconductrice déposée sur le substrat, de préférence sur une couche tampon, sur un deuxième côté opposé audit premier côté dudit substrat,
• un contact supraconducteur de grande envergure établi en roulant ledit substrat avec lesdites couches supraconductrices déposées, établissant ainsi ledit contact de grande envergure entre la surface de ladite première couche supraconductrice et la surface de ladite deuxième couche supraconductrice, ledit contact de grande envergure s'étendant sur au moins une fraction de f = 0,3 de la longueur et de la largeur desdits supraconducteurs,
• au moins une desdites couches supraconductrices comprenant un composé appartenant à la famille ReBa₂Cu₃O_{7-δ}, Re étant une terre rare incluant La ou Y.

4. Supraconducteur selon l'une quelconque des revendications précédentes, *dans lequel*
les couches supraconductrices en contact sont de préférence de longueurs ou de largeurs différentes, et ledit contact s'étend au moins sur une fraction d'environ f = 0,5 de la longueur et de la largeur de l'une desdites couches supraconductrices.

5. Supraconducteur selon l'une quelconque des revendications précédentes, *dans lequel*
les grains dans au moins une couche supraconductrice sont alignés de sorte que l'on obtient des limites de grains à angle faible.

6. Supraconducteur selon l'une quelconque des revendications précédentes, *dans lequel*
la longueur moyenne des grains dans au moins une couche supraconductrice dépasse leur largeur moyenne selon au moins un facteur de 1,5.

7. Supraconducteur selon l'une quelconque des revendications précédentes, *dans lequel*
au moins une des couches supraconductrices est constituée d'une hétérostructure.

8. Supraconducteur selon la revendication 7, *dans lequel*
l'hétérostructure comprend au moins un film dopeur.

9. Supraconducteur selon l'une quelconque des revendications précédentes, *dans lequel*
le contact supraconducteur est établi en pressant les unes contre les autres les couches supraconductrices par des moyens mécaniques.

10. Supraconducteur selon l'une quelconque des revendications 1 à 9, *dans lequel*
le contact supraconducteur est établi en réunissant les couches supraconductrices entre elles par frittage et/ou par brasage.

11. Supraconducteur selon l'une quelconque des revendications 1 à 9, *dans lequel*
le contact supraconducteur est établi en réunissant les couches supraconductrices entre elles par soudage.

12. Supraconducteur selon la revendication 10 ou 11, *dans lequel*
le contact supraconducteur est établi pendant que la pression est appliquée.

13. Supraconducteur selon l'une quelconque des revendications 9 à 12, *dans lequel*
le contact supraconducteur est établi en réalisant une couche intermédiaire, en particulier une couche intermédiaire déposée sur au moins une des couches supraconductrices.

14. Supraconducteur selon la revendication 13, *dans lequel*
la couche intermédiaire comprend une poudre déposée sur au moins une des couches supraconductrices.

15. Supraconducteur selon l'une quelconque des revendications précédentes, *dans lequel*
au moins un des substrats est enlevé avant d'établir le contact supraconducteur entre les surfaces des couches supraconductrices.

16. Supraconducteur selon l'une quelconque des revendications précédentes, *dans lequel*
au moins une couche supraconductrice est séparée en pièces avant d'établir le contact supraconducteur.

17. Supraconducteur selon l'une quelconque des revendications précédentes, *dans lequel*
au moins un des composés supraconducteurs utilisés dans l'une quelconque des couches supraconductrices est un cuprate.

18. Supraconducteur selon la revendication 1, *dans lequel*
au moins un des composés supraconducteurs utilisés dans l'une quelconque des couches supraconductrices appartient à la famille ReBa₂Cu₃O_{7-δ}, Re étant une terre rare incluant La ou Y.

19. Supraconducteur selon la revendication 18, *dans lequel*
• des substrats métalliques sont prévus,
• le composé supraconducteur de la famille ReBa₂Cu₃O_{7-δ} est déposé sur les deux côtés desdits substrats, de préférence sur des couches tampons, et
• au moins deux de ces substrats portant des couches supraconductrices sont montés l'un sur l'autre sur au moins un tiers de leur longueur ou largeur.

20. Procédé de fabrication d'un supraconducteur étendu, par exemple un fil, une bande, ou une feuille, ***caractérisé par***
• la réalisation d'au moins deux substrats, chacun d'une longueur d'au moins 1 m, de préférence de plusieurs m,
• le dépôt d'une couche supraconductrice sur chaque dit substrat, sur au moins un côté, de préférence sur une couche tampon intermédiaire sur ledit substrat,
• l'établissement d'un contact supraconducteur de grande envergure entre les surfaces desdites couches supraconductrices, ledit contact supraconducteur s'étendant sur au moins une fraction de f = 0,3 de la longueur et de la largeur desdites couches supraconductrices en réunissant lesdits deux substrats avec leurs côtés supraconducteurs se faisant face.

21. Procédé de fabrication d'un supraconducteur étendu, par exemple un fil, une bande, ou une feuille, ***caractérisé par***
• la réalisation d'un substrat unique, d'une longueur d'au moins 1 m,
• le dépôt d'au moins une couche supraconductrice sur le substrat, de préférence sur une couche tampon intermédiaire sur ledit substrat,
• le pliage ou la torsion dudit substrat sur lui-même de sorte que différentes zones de ladite couche supraconductrice établissent un contact supraconducteur de grande envergure s'étendant sur au moins une fraction de f = 0,3 de la longueur et de la largeur desdites différentes zones de ladite couche supraconductrice,
• au moins une desdites couches supraconductrices comprenant un composé appartenant à la famille ReBa₂Cu₃O_{7-δ}, Re étant une terre rare incluant La ou Y.

22. Procédé de fabrication d'un supraconducteur étendu, par exemple un fil, une bande, ou une feuille, ***caractérisé par***
• la réalisation d'un substrat unique, d'une longueur d'au moins 1 m,
• le dépôt d'une première couche supraconductrice sur un premier côté dudit substrat, de préférence sur une couche tampon, et
• le dépôt d'une deuxième couche supraconductrice sur un deuxième côté, opposé audit premier côté, dudit substrat, de préférence sur une couche tampon,
• le roulage dudit substrat avec lesdites couches supraconductrices déposées de sorte qu'un contact de grande envergure entre la surface de ladite première couche supraconductrice et la surface de ladite deuxième couche supraconductrice est établi, ledit contact de grande envergure s'étendant sur
au moins une fraction de f = 0,3 de la longueur et de la largeur desdits supraconducteurs,
• au moins une desdites couches supraconductrices comprenant un composé appartenant à la famille ReBa₂Cu₃O_{7-δ,} Re étant une terre rare incluant La ou Y.

23. Procédé de fabrication d'un supraconducteur selon la revendication 20, 21 ou 22, *dans lequel*
la couche supraconductrice est obtenue en déposant un composé supraconducteur sur un substrat, de préférence sur une couche tampon sur ledit substrat, produisant ainsi une multicouche, et en séparant ou en épissant ensuite la multicouche ainsi obtenue.
